# EUROPÄISCHE PATENTSCHRIFT

(11) **EP 2 789 217 B1**
(45) Veröffentlichungstag und Bekanntmachung des Hinweises auf die Patenterteilung: **13.12.2017**
(21) Anmeldenummer: 12784486.8
(22) Anmeldetag: 11.10.2012
(51) Int. Cl.: H05K 5/06, H05K 5/00, F16H 61/00

(54) **ANORDNUNG EINES ELEKTRONIKMODULS ZWISCHEN GETRIEBERAUM UND MOTORRAUM UND VERFAHREN ZUR MONTAGE DAVON**
ARRANGEMENT OF AN ELECTRONIC MODULE BETWEEN A TRANSMISSION COMPARTMENT AND AN ENGINE COMPARTMENT
MODULE ÉLECTRONIQUE DISPOSÉ ENTRE LA CHAMBRE DE TRANSMISSION ET LE COMPARTIMENT-MOTEUR

(30) Priorität: 08.12.2011 DE 102011088037
(43) Veröffentlichungstag der Anmeldung: 15.10.2014
(73) Patentinhaber: Robert Bosch GmbH, 70442 Stuttgart (DE)
(72) Erfinder: BRAUN, Holger, 70435 Stuttgart (DE); RUDEL, Jens, 71701 Schwieberdingen (DE)
(86) Internationale Anmeldenummer: PCT/EP2012/070178
(87) Internationale Veröffentlichungsnummer: WO 2013/083319

(56) Entgegenhaltungen:
- EP-A1- 1 489 339
- EP-A2- 1 193 423
- DE-A1-102008 014 457
- DE-A1-102010 028 621
- DE-C1- 10 051 945

## Beschreibung

### Stand der Technik

Zur Steuerung eines Getriebes, z.B. in einem Motor eines Fahrzeugs, sind elektronische Steuerungen nötig. Diese können z.B. im Inneren des Getriebegehäuses angeordnet werden oder von außen an das Getriebegehäuse montiert werden. Siehe zum Beispiel die EP-A-1193423. Ein im Getriebeinneren angeordnetes Steuergerät kann als integriertes Steuergerät bezeichnet werden und kann direkt an einer hydraulischen Steuereinheit montiert sein. Eine Kombination aus Elektronik- und Hydraulikmodul kann als Mechatronik bezeichnet werden. Die Mechatronik wird durch eine Öffnung in das Getriebegehäuse eingesetzt. Anschließend wird die Öffnung durch einen Deckel, auch als Ölwanne bezeichnet, verschlossen.
Ein integriertes Steuergerät weist eine elektronische Schaltung (TCU), Sensoren, eine Steckverbindung zum Anschluss an eine Energieversorgung und elektrische Schnittstellen zum Ansteuern von Aktuatoren auf. Der Anschluss an die Energieversorgung bzw. an einen Kabelbaustecker muss über einen dichten Stecker erfolgen, der durch das Gehäuse oder den Deckel geführt werden muss. Der Kabelbaustecker ist jedoch i.d.R. bereits vor der Durchführung durch das Gehäuse starr mit der Hydraulikeinheit verbunden. Daher muss dieser mechanisch flexibel ausgeführt werden um einen Toleranzausgleich zu ermöglichen. Dies kann arbeitsaufwändig sein. Ein integriertes Steuergerät ist dabei ferner z.B. Getriebeöl und hohen Temperaturen von bis zu 150° C ausgesetzt. Als Schaltungsträger muss wegen der hohen Temperaturen z.B. ein Keramiksubstrat verwendet werden. Dies kann mit hohen Kosten verbunden sein.

Ein von außen an das Getriebegehäuse montiertes Steuergerät kann im an den Getrieberaum angrenzenden Motorraum angeordnet sein und wird als Anbausteuergerät bezeichnet. Das Anbausteuergerät kann etwas niedrigeren Temperaturen von bis zu 120° C ausgesetzt sein als das integrierte Steuergerät. Als Schaltungsträger kann hier eine Leiterplatte, auch als Printed Circuit Board (PCB) bezeichnet, verwendet werden. Allerdings benötigt ein Anbausteuergerät viel Bauraum im Motorraum. Ferner ist die Installation eines Anbausteuergeräts mit hohem Arbeitsaufwand verbunden, da elektrische Leitungen vom Steuergerät zu den im Inneren des Getriebes liegenden Sensoren und Aktuatoren geführt und abgedichtet werden müssen. Die Anzahl der Leitungen, die am Getriebegehäuse abgedichtet werden müssen kann dabei höher als bei einem Kabelbaumstecker eines integrierten Steuergeräts sein.

### Offenbarung der Erfindung

Es kann daher ein Bedarf an einer Möglichkeit bestehen, die oben genannten Nachteile sowohl des integrierten Steuergeräts als auch des Anbausteuergeräts zu überwinden.

Diese Aufgabe kann durch den Gegenstand der vorliegenden Erfindung gemäß den unabhängigen Ansprüchen gelöst werden. Vorteilhafte Ausführungsformen der vorliegenden Erfindung sind in den abhängigen Ansprüchen beschrieben.

Im Folgenden werden Merkmale, Einzelheiten und mögliche Vorteile einer Vorrichtung gemäß Ausführungsformen der Erfindung im Detail diskutiert.

Gemäß einem ersten Aspekt der Erfindung wird ein Durchkontaktierungs-Element zur Anordnung zwischen einem Getrieberaum und einem Motorraum vorgestellt. Das Durchkontaktierungs-Element weist eine Basisplatte mit mindestens einer Ausnehmung und mindestens ein Submodul mit elektrischen Leitungen auf. Das Submodul ist in der Ausnehmung der Basisplatte angeordnet und stoffschlüssig und öldicht mit der Basisplatte verbunden. Das Durchkontaktierungs-Element ist dabei ausgeführt den Getrieberaum vom Motorraum öldicht zu trennen.

Anders ausgedrückt basiert die Idee der vorliegenden Erfindung darauf, ein Durchkontaktierungs-Element vorzusehen, das ein Getriebe gegen den Motorraum öldicht verschließt und gleichzeitig z.B. sämtliche elektrische Verbindungen enthält, die vom Motorraum in den Getrieberaum geführt werden müssen. Das Durchkontaktierungs-Element kann dabei z.B. an einem Getriebegehäuse angeordnet werden und sowohl ein Sensormodul als auch einen Getriebestecker ersetzen. Ferner kann das Durchkontaktierungs-Element eine öldichte Getriebeabdeckung ersetzen. Öldicht bedeutet dabei undurchlässig für Öl, insbesondere für Getriebeöl.

In Kombination mit dem erfindungsgemäßen Durchkontaktierungs-Element kann ein Schaltungsträger als Hybrid aus integriertem Steuergerät und Anbausteuergerät ausgeführt sein. Z.B. kann ein Schaltungsträger direkt am Durchkontaktierungs-Element auf der Motorraumseite angeordnet sein und hierdurch niedrigeren Temperaturen ausgesetzt sein als im Getriebeinneren. Hierdurch kann eine vergleichsweise kostengünstige Leiterplatte verwendet werden. Des Weiteren ist der Schaltungsträger direkt am Übergang zwischen Motorraum und Getrieberaum angeordnet und nimmt somit keinen Bauraum im Motorraum ein. Ferner entfallen dank dem erfindungsgemäßen Durchkontaktierungs-Element die Arbeitsschritte der Durchführung von elektrischen Leitungen durch das Getriebegehäuse und des Abdichtens dieser Leitungen, weil die Submodule mit den entsprechenden elektrischen Leitungen bereits in die Basisplatte öldicht integriert sind.

Die Basisplatte kann dabei einen Kunststoff aufweisen bzw. aus Kunststoff bestehen. Die Ausnehmungen der Basisplatte werden bereits bei der Herstellung so vorgesehen, dass die eingesetzten Submodule genau an der richtigen Position in Bezug auf korrespondierende Elemente im Getriebeinneren ausgerichtet sind. Die Ausnehmungen können dabei etwas größer als die entsprechenden Submodule dimensioniert sein, um Fertigungstoleranzen auszugleichen. Z.B. können die Submodule mit Hilfe einer sogenannten Lehre in die Basisplatte montiert werden.

Die stoffschlüssige Verbindung zwischen Basisplatte und Submodulen ist eine nicht lösbare Verbindung, bei der die Basisplatte auf atomarer bzw. molekularer Ebene mit den Submodulen verbunden ist. Z.B. kann die Verbindung durch Schweißen oder Kleben hergestellt werden. Vorzugsweise wird die stoffschlüssige Verbindung durch Laserschweißen oder Reibschweißen hergestellt. Hierdurch entsteht eine öldichte Verbindung, so dass die elektrischen Verbindungen der Submodule öldicht vom Motorraum in den Getrieberaum geführt werden können.

Gemäß einem Ausführungsbeispiel der Erfindung können die einzelnen Submodule z.B. als Sensoren, Stecker, Kupplungen und/oder Verteiler ausgeführt sein. Die Submodule können ein Kunststoffgehäuse mit darin befindlichen elektrischen Leitungen und ggf. elektrischen Bauelementen aufweisen. Beispielsweise kann ein erstes Submodul als Drucksensor oder als Temperatursensor ausgeführt sein. Ein zweites Submodul kann als Ersatz für einen Gerätestecker z.B. zum Anschluss an einen zusätzlichen Drehzahlsensor fungieren. Ein drittes Submodul kann z.B. als Verteiler ausgeführt sein. Dabei sind in der Basisplatte vorzugsweise mehrere Submodule integriert. Beispielsweise kann für jedes Funktionselement ein separates Submodul vorgesehen sein. Auf diese Weise können die einzelnen Funktionselemente unabhängig voneinander hergestellt werden. Durch die Integration der einzelnen Submodule in Ausnehmungen der Basisplatte kann ferner auf eine Führung der gesamten Basisplatte durch einen Ofenprozess verzichtet werden.

Die Submodule, insbesondere Stecker und Verteiler, können zusätzlich an einer dem Motorraum zugewandten Seite abgedichtet sein. Hierzu können die elektrischen Verbindungen Motorraumseitig durch Epoxydharz-Verguss oder durch eingepresste Rundpins öldicht versiegelt werden.

Gemäß einem weiteren Ausführungsbeispiel der Erfindung weist das Durchkontaktierungs-Element ferner eine Abdeckung auf. Die Abdeckung, auch als Deckel bezeichnet, ist auf einer dem Motorraum zugewandten Seite der Basisplatte angeordnet, wenn das Durchkontaktierungs-Element zwischen Getrieberaum und Motorraum eingebaut bzw. positioniert ist. Die Abdeckung ist durch erste Befestigungselemente an einem Gehäuse des Getrieberaums befestigbar. Die Abdeckung kann z.B. ein Metall aufweisen bzw. aus Metall bestehen. Dabei kann die Abdeckung einen Schlagschutz für die Basisplatte und einen an der Basisplatte angeordneten Schaltungsträger bieten.

Zwischen Basisplatte und Abdeckung kann ein Schaltungsträger mit elektronischen Bauelementen vorgesehen sein. Dieser bildet zusammen mit dem Durchkontaktierungs-Element ein elektronisches Steuermodul.

Gemäß einem weiteren Ausführungsbeispiel der Erfindung ist die Abdeckung durch zweite Befestigungselemente an der dem Motorraum zugewandet Seite der Basisplatte befestigt. Hierbei können die zweiten Befestigungselemente von der Motorraumseite die Abdeckung durchdringen, durch Ausnehmungen in dem Schaltungsträger verlaufen und mit entsprechenden Aufnahmeelementen in der Basisplatte eingreifen. Gemäß einem weiteren Ausführungsbeispiel ist der Schaltungsträger durch dritte Befestigungselemente an der Abdeckung befestigt. Die dritten Befestigungselemente können zusätzlich oder alternativ zu den zweiten Befestigungselementen vorgesehen sein.

Sowohl die zweiten als auch die dritten Befestigungselemente sorgen dafür, dass die Basisplatte und ggf. ein darauf befindlicher Schaltungsträger mit der Abdeckung verbunden sind. Bei der Befestigung dieser Elemente entsteht keine Verbindung zwischen Motorraum und Getrieberaum, so dass die zweiten bzw. dritten Befestigungselemente nicht gegen einen Austritt von Öl abgedichtet werden müssen.

Die ersten, zweiten und dritten Befestigungselemente können jeweils z.B. als, Nieten, Einschnapp-Verbindungen und/oder Schrauben ausgeführt sein.

Gemäß einem zweiten Aspekt der Erfindung wird ein elektronisches Steuermodul vorgestellt. Das elektronische Steuermodul weist einen Schaltungsträger mit elektronischen Bauelementen und ein oben beschriebenes Durchkontaktierungs-Element auf. Die elektronischen Bauelemente, wie z.B. Dioden, Kondensatoren und Transistoren sind elektrisch mit dem Submodul verbunden und auf der dem Motorraum zugewandten Seite des Schaltungsträgers angerordnet. Hierdurch sind die elektronischen Bauelemente von dem Getrieberaum wegorientiert und können durch im Motorraum herrschende niedrigere Temperaturen ggf. gekühlt werden.

Der Schaltungsträger ist dabei an einer dem Motorraum zugewandten Seite der Basisplatte angeordnet. D.h. die elektronischen Bauelemente sind an einer von der Basisplatte abgewandten Seite des Schaltungsträgers positioniert. Der Schaltungsträger weist ein Kunststoffmaterial auf bzw. besteht aus einem Kunststoffmaterial. Dies ist dadurch möglich, dass der Schaltungsträger den im Getrieberaum herrschenden hohen Temperaturen nicht ausgesetzt ist, sondern durch die Basisplatte geschützt ist.

Gemäß einem dritten Aspekt der Erfindung wird ein Verfahren zur Herstellung und Montage eines oben dargestellten elektronischen Steuermoduls vorgestellt. Das Verfahren weist die folgenden Schritte auf: Bereitstellen einer Basisplatte mit einer Ausnehmung; Bereitstellen eines Submoduls mit Leitungen; und Bereitstellen eines Schaltungsträgers; Durchführen des Submodules durch die Ausnehmung; Verbinden, insbesondere Verlöten, der elektrischen Leitungen des Submoduls mit dem Schaltungsträger; und Stoffschlüssiges und öldichtes Verbinden, insbesondere Verschweißen, des Submodules mit der Basisplatte. Bei der Herstellung der Basisplatte können bereits Fertigungstoleranzen in der Positionierung und Dimensionierung der Ausnehmungen berücksichtigt werden, so dass genügend Spielraum für die Submodule eingeplant wird.

Gemäß einem weiteren Ausführungsbeispiel der Erfindung weist das Verfahren ferner die folgenden Schritte auf: Bereitstellen einer Abdeckung; Befestigen, insbesondere Verschrauben, der Abdeckung durch zweite Befestigungselemente an der Basisplatte.

Gemäß einem weiteren Ausführungsbeispiel der Erfindung kann das Herstellungsverfahren alternativ aufweisen: Bereitstellen einer Abdeckung; Verbinden, insbesondere Verlöten, der elektrischen Leitungen des Submoduls mit dem Schaltungsträger bevor das Submodul mit der Basisplatte verbunden ist; Befestigen, insbesondere Verschrauben, des Schaltungsträgers durch dritte Befestigungselemente an der Abdeckung bevor das Submodul mit der Basisplatte verbunden ist. Auf diese Weise kann erreicht werden, dass die dritten Befestigungselemente weder eine Verbindung zum Motorraum noch eine Verbindung zum Getrieberaum haben und damit nicht abgedichtet werden müssen.

Gemäß einem weiteren Ausführungsbeispiel der Erfindung weist das Verfahren ferner auf: Anordnen der Basisplatte an einem Gehäuse eines Getriebes zwischen einem Getrieberaum und einem Motorraum; Vorsehen eines Dichtelements, insbesondere eines Dichtrings, zwischen der Basisplatte und dem Getriebegehäuse; Verbinden der Abdeckung durch erste Befestigungselemente mit dem Gehäuse des Getriebes.

Das Durchkontaktierungs-Element und das elektronische Steuermodul können z.B. im Getriebe eines Fahrzeugs, insbesondere in einem Automatikgetriebe eingesetzt werden. Das elektronische Steuermodul kann z.B. als hydraulische oder als elektro-mechanische Steuereinheit ausgeführt sein.

Weitere Merkmale und Vorteile der vorliegenden Erfindung werden dem Fachmann aus der nachfolgenden Beschreibung beispielhafter Ausführungsformen, die jedoch nicht als die Erfindung beschränkend auszulegen sind, unter Bezugnahme auf die beigelegten Zeichnungen ersichtlich.
- Fig. 1: zeigt einen Querschnitt durch ein Durchkontaktierungs-Element gemäß einem Ausführungsbeispiel der Erfindung
- Fig. 2: zeigt einen Querschnitt durch ein elektrisches Steuermodul gemäß einem Ausführungsbeispiel der Erfindung
- Fig. 3: zeigt einen Querschnitt durch ein elektrisches Steuermodul gemäß einem weiteren Ausführungsbeispiel der Erfindung
- Fig. 4: zeigt ein Blockdiagramm eines Verfahrens zur Montage eines elektrischen Steuermoduls gemäß einem Ausführungsbeispiel der Erfindung
- Fig. 5: zeigt ein Blockdiagramm eines Verfahrens zur Montage eines elektrischen Steuermoduls gemäß einem weiteren Ausführungsbeispiel der Erfindung

Alle Figuren sind lediglich schematische Darstellungen erfindungsgemäßer Vorrichtungen bzw. ihrer Bestandteile gemäß Ausführungsbeispielen der Erfindung. Insbesondere Abstände und Größenrelationen sind in den Figuren nicht maßstabsgetreu wiedergegeben. In den verschiedenen Figuren sind sich entsprechende Elemente mit den gleichen Referenznummern versehen.

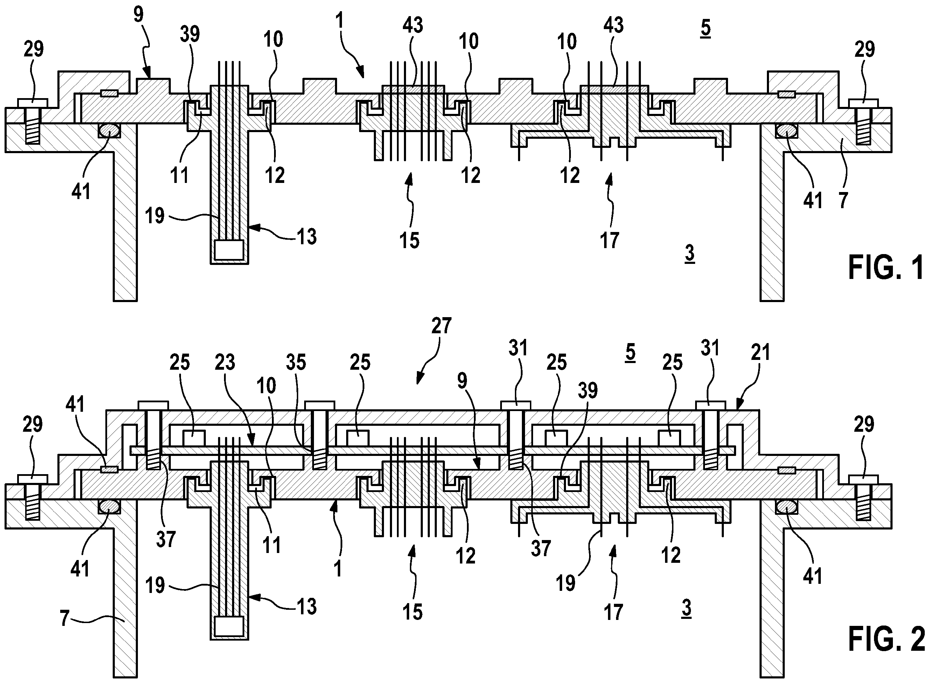

In Fig. 1 ist ein Durchkontaktierungs-Element 1 dargestellt, welches zwischen einem Getrieberaum 3 und einem Motorraum 5 eines Fahrzeuggetriebes angeordnet ist. Das Durchkontaktierungs-Element 1 ist an einer Öffnung des Getriebes an einem Getriebegehäuse 7 angeordnet und mittels eines Dichtelements 41, z.B. eines Dichtrings, abgedichtet.

Das Durchkontaktierungs-Element 1 weist eine Basisplatte 9 auf, in die mehrere Submodule 13, 15, 17 mit elektrischen Leitungen 19 integriert sind. Z.B. ist ein erstes Submodul 13 als Sensor, ein zweites Submodul 15 als Stecker, und ein drittes Submodul 17 als Verteiler ausgeführt. Die Submodule 13, 15, 17 sind durch Ausnehmungen 11 in der Basisplatte 9 geführt. Die Ausnehmungen 11 können z.B. kreisförmig ausgeführt sein und derart positioniert sein, dass die Submodule 13, 15, 17 genau gegenüber korrespondierenden Elementen im Getrieberaum 3 angeordnet sind, wenn das Durchkontaktierungs-Element 1 an der vorgesehenen Stelle zwischen Getrieberaum 3 und Motorraum 5 angeordnet ist.

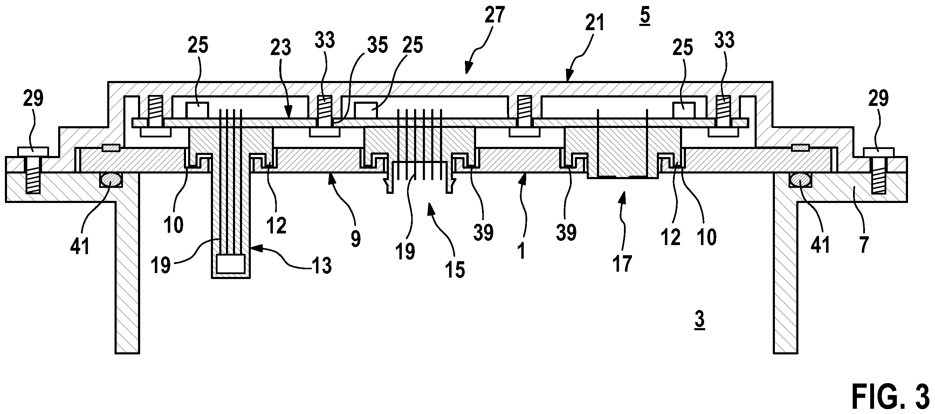

An den Submodulen 13, 15, 17 sind Positionierungselemente 12 vorgesehen, die an einer Seite der Basisplatte 9 mit dafür vorgesehenen Positionierungsaufnahmen 10 eingreifen. In Fig. 1 und 2 sind die Positionierungsaufnahmen 10 an der dem Getrieberaum 3 zugewandten Seite der Basisplatte 9 vorgesehen. D.h. die Submodule 13, 15, 17 werden z.B. von unten durch die Basisplatte 9 geführt. In Fig. 3 sind die Positionierungsaufnahmen 10 auf der dem Motorraum 5 zugewandten Seite der Basisplatte 9 vorgesehen. D.h. die Submodule 13, 15, 17 werden z.B. von oben durch die Basisplatte 9 geführt.

Die Submodule 13, 15, 17 sind in den dargestellten Ausführungsbeispielen mittels eines Laserschweißverfahrens an den Laserschweißstellen 39 stoffschlüssig und öldicht mit der Basisplatte verbunden. Dieser Verbindungsprozess dient der Positionierung und Fixierung der Submodule 13, 15, 17 an der Basisplatte 9. Submodule 15, 17 wie Stecker und Verteiler sind öldicht vom Motorraum 5 in den Getrieberaum 3 geführt. Hierzu ist Motorraumseitig eine Abdichtung 43 wie Epoxydharz-Verguss oder eingepresste Rundpins an diesen Submodulen 15, 17 vorgesehen.

Das Durchkontaktierungs-Element 1 enthält sämtliche elektrischen Ein- und Ausgänge zwischen Getrieberaum 3 und Motorraum 5. Ferner dichtet das Durchkontaktierungs-Element 1 den Getrieberaum 3 vom Motorraum 5 durch ein ölresistentes Material ab. Dabei dient das Durchkontaktierungs-Element 1 gleichzeitig als Sensormodul, Getriebestecker und Getriebeabdeckung. Hierzu ist die Basisplatte 9 durch erste Befestigungselemente 29 mit dem Getriebegehäuse 7 verschraubt.

In Fig. 2 und 3 sind alternative Ausführungsformen eines elektrischen Steuermoduls 27 dargestellt. Sowohl in Fig. 2 als auch in Fig. 3 weist das elektrische Steuermodul 27 ein Durchkontaktierungs-Element 1 auf, an dem Motorraum-seitig ein Schaltungsträger 23 mit elektronischen Bauelementen 25 angeordnet ist. Der Schaltungsträger 23 ist als Leiterplatte (PCB) ausgeführt und die elektronischen Bauelemente 25 sind Motorraum-seitig am Schaltungsträger 23 angeordnet. Auf diese Weise kann die im Vergleich zum Getrieberaum 3 geringe Umgebungstemperatur des Motorraums 5 für die Kühlung der elektronischen Bauelemente 25 genutzt werden. Hierdurch können ggf. günstigere elektronische Bauelemente 25 verwendet werden.

Der Schaltungsträger 23 wird von der Seite des Motorraums 5 durch eine z.B. metallische Abdeckung 21 geschützt. Die Abdeckung 21 ist durch erste Befestigungselemente 29 mit dem Getriebegehäuse 7 verschraubt und fixiert dadurch das elektrische Steuermodul 27 in Bezug auf den Getrieberaum 3 und in Bezug auf den Motorraum 5.

In Fig. 2 ist die Abdeckung 21 ferner durch zweite Befestigungselemente 31 mit dem Schaltungsträger 23 und insbesondere mit der Basisplatte 9 befestigt. Dabei sind die zweiten Befestigungselemente 31 Motorraum-seitig angebracht. Die zweiten Befestigungselemente 31 werden dabei durch Ausnehmungen 35 im Schaltungsträger 23 geführt und greifen mit Aufnahmeelementen 37 in der Basisplatte 9 ein. Auf diese Weist besteht keine offene Verbindung zwischen dem Motorraum 5 und dem Getrieberaum 3. Somit müssen die zweiten

Befestigungselemente 31 nicht gegen einen Austritt von Öl aus dem Getriebe abgedichtet werden.

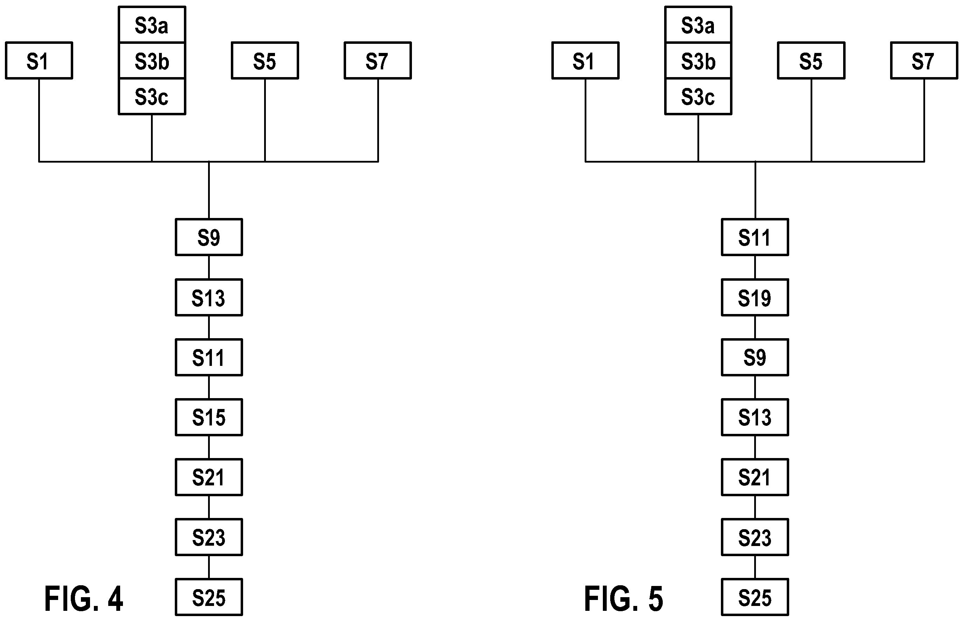

Fig. 4 zeigt ein mögliches Herstellungs- bzw. Montageverfahren für das in Fig. 2 gezeigte elektrische Steuermodul 27. Zunächst wird eine Basisplatte 9 mit mehreren Ausnehmungen 11 bereitgestellt S1. Ferner werden mehrere Submodule 13, 15, 17 mit elektrischen Leitungen 19 bereitgestellt S3a, S3b, S3c. Des Weiteren wird ein Schaltungsträger 23 bereitgestellt S5. Ferner wird eine Abdeckung 21 bereitgestellt. Diese Schritte S1, S3a, S3b, S3c, S5, S7 können gleichzeitig oder sequentiell ausgeführt werden.

Anschließend können die Submodule 13, 15, 17 durch die Ausnehmungen 11 durchgeführt S9 und mit der Basisplatte 9 stoffschlüssig und öldicht verbunden S13 werden. Danach wird der Schaltungsträger 23 an der Basisplatte 9 angeordnet und die elektrischen Leitungen 19 der Submodule 13, 15, 17 mit dem Schaltungsträger 23 verlötet S11. Ferner wird die Abdeckung 21 durch die zweiten Befestigungselemente 31 an der Basisplatte 9 befestigt S15. Daraufhin wird die Basisplatte 9 an dem Getriebegehäuse 7 zwischen dem Getrieberaum 3 und dem Motorraum 5 angeordnet S21 und ein Dichtelement 41 zwischen der Basisplatte 9 und dem Getriebegehäuse 7 vorgesehen S23. Schließlich wird die Abdeckung 21 durch erste Befestigungselemente 29 an dem Getriebegehäuse 7 befestigt S25.

Im Unterschied zu Fig. 2 sind die Submodule 13, 15, 17 in dem in Fig. 3 gezeigten Ausführungsbeispiel von oben in die Basisplatte 9 beingesetzt. Ferner sind in Fig. 3 statt der zweiten Befestigungselemente 31 dritte Befestigungselemente 33 vorgesehen, die den Schaltungsträger 23 mit der Abdeckung 21 verbinden. Die dritten Befestigungselemente 33 weisen auf diese Weise weder eine Verbindung zum Getrieberaum 3 noch zum Motorraum 5 auf und müssen nicht abgedichtet werden. Das in Fig. 3 dargestellte elektrische Steuermodul 27 unterscheidet sich ferner im Herstellungs- bzw. Montageverfahren vom in Fig. 2 gezeigten Ausführungsbeispiel.

Fig. 5 zeigt ein mögliches Herstellungs- bzw. Montageverfahren für das in Fig. 3 dargestellte elektrische Steuermodul 27. Nach dem Bereitstellen S1, S3a, S3b, S3c, S5, S7 der notwendigen Komponenten werden zunächst die elektrischen Leitungen 19 der Submodule 13, 15, 17 mit dem Schaltungsträger 23 verbunden S11. Anschließend wird die Baugruppe aus Submodulen 13, 15, 17 und Schaltungsträger 23 in die Abdeckung 21 integriert S19, indem dritte Befestigungselemente 33 durch entsprechende Ausnehmungen in dem Schaltungsträger 23 geführt werden und mit Aufnahmeelementen der Abdeckung 21 eingreifen. Danach werden die Submodule 13, 15, 17 durch die Ausnehmungen 11 der Basisplatte 9 geführt S9 und stoffschlüssig und öldicht mit der Basisplatte 9 verschweißt S13. Das weitere Verfahren läuft in Analogie zum Verfahren in Fig. 4 ab.
In einem in den Fig. nicht gezeigten Ausführungsbeispiel kann der Schaltungsträger 23 außerhalb des Zwischenraums zwischen dem Getrieberaum 3 und dem Motorraum 5 angeordnet sein. D.h. der Schaltungsträger 23 kann im Motorraum 5 positioniert sein und mittels eines Kabelbaums mit den Submodulen 13, 15, 17 in der Basisplatte 9 verbunden sein.
Abschließend wird angemerkt, dass Ausdrücke wie "aufweisend" oder ähnliche nicht ausschließen sollen, dass weitere Elemente oder Schritte vorgesehen sein können. Des Weiteren sei darauf hingewiesen, dass _{"}eine" oder _{"}ein" keine Vielzahl ausschließen. Es wird ferner angemerkt, dass die Bezugszeichen in den Ansprüchen nicht als den Umfang der Ansprüche beschränkend ausgelegt werden sollen.

## Patentansprüche

1. Durchkontaktierungs-Element (1) zur Anordnung zwischen einem Getrieberaum (3) und einem Motorraum (5), das Durchkontaktierungs-Element (1) aufweisend
eine Basisplatte (9), in der eine Ausnehmung (11) vorgesehen ist;
ein Submodul (13, 15, 17) mit elektrischen Leitungen (19);
wobei das Submodul (13, 15, 17) in der Ausnehmung (11) der Basisplatte (9) angeordnet ist;
**dadurch gekennzeichnet, dass**
das Submodul (13, 15, 17) stoffschlüssig und öldicht mit der Basisplatte (9) verbunden ist; und
dass das Durchkontaktierungs-Element (1) ausgeführt ist, den Getrieberaum (3) vom Motorraum (5) öldicht zu trennen.

2. Durchkontaktierungs-Element (1) gemäß Anspruch 1,
wobei das Submodul (13, 15, 17) als Sensor, Stecker, Kupplung und/oder Verteiler ausgeführt ist.

3. Durchkontaktierungs-Element (1) gemäß einem der Ansprüche 1 und 2, ferner aufweisend
eine Abdeckung (21);
wobei die Abdeckung (21) auf einer dem Motorraum (5) zugewandten Seite der Basisplatte (9) angeordnet ist;
wobei die Abdeckung (21) mittels ersten Befestigungselementen (29) an einem Gehäuse (7) des Getrieberaums (3) befestigbar ist.

4. Durchkontaktierungs-Element (1) gemäß Anspruch 3,
wobei die Abdeckung (21) durch zweite Befestigungselemente (31) an der dem Motorraum (5) zugewandet Seite der Basisplatte (9) befestigt ist.

5. Elektronisches Steuermodul (27), das Steuermodul (27) aufweisend
einen Schaltungsträger (23) mit elektronischen Bauelementen (25);
ein Durchkontaktierungs-Element (1) gemäß einem der Ansprüche 1 bis 4;
wobei die elektronischen Bauelemente (25) elektrisch mit dem Submodul (13, 15, 17) verbunden sind;
wobei der Schaltungsträger (23) an einer dem Motorraum (5) zugewandten Seite der Basisplatte (9) angeordnet ist;
wobei der Schaltungsträger (23) ein Kunststoffmaterial aufweist.

6. Elektronisches Steuermodul (27) gemäß Anspruch 5,
wobei die elektronischen Bauelemente (25) an einer dem Motorraum (5) zugewandten Seite des Schaltungsträgers (23) angeordnet sind.

7. Elektronisches Steuermodul (27) gemäß einem der Ansprüche 5 und 6,
wobei der Schaltungsträger (23) durch dritte Befestigungselemente (33) an der Abdeckung (21) befestigt ist.

8. Verfahren zur Montage eines elektronischen Steuermoduls (27) gemäß einem der Ansprüche 5 bis 7, das Verfahren aufweisend die folgenden Schritte
Bereitstellen (S1) einer Basisplatte (9) mit einer Ausnehmung (11); Bereitstellen (S3a, S3b, S3c) eines Submoduls (13, 15, 17) mit Leitungen (19);
Bereitstellen (S5) eines Schaltungsträgers (23);
Durchführen (S9) des Submodules (13, 15, 17) durch die Ausnehmung (11); Verbinden (S11) der elektrischen Leitungen (19) des Submoduls (13, 15, 17) mit dem Schaltungsträger (23);
**dadurch gekennzeichnet, dass** das Verfahren ferner aufweist Stoffschlüssiges und öldichtes Verbinden (S13) des Submodules (13, 15, 17) mit der Basisplatte (9).

9. Verfahren gemäß Anspruch 8, ferner aufweisend
Bereitstellen (S7) einer Abdeckung (21);
Befestigen (S15) der Abdeckung (21) durch zweite Befestigungselemente (31) an der Basisplatte (9).

10. Verfahren gemäß Anspruch 8, ferner aufweisend
Bereitstellen (S7) einer Abdeckung (21);
Verbinden (S11) der elektrischen Leitungen (19) des Submoduls (13, 15, 17) mit dem Schaltungsträger (23) bevor das Submodul (13, 15, 17) mit der Basisplatte (9) verbunden ist;
Befestigen (S19) des Schaltungsträgers (23) durch dritte Befestigungselemente (33) an der Abdeckung (21) bevor das Submodul (13, 15, 17) mit der Basisplatte (9) verbunden ist.

11. Verfahren gemäß einem der Ansprüche 9 und 10, ferner aufweisend Anordnen (S21) der Basisplatte (9) an einem Gehäuse (7) eines Getrieberaums (3) zwischen dem Getrieberaum (3) und einem Motorraum (5);
Vorsehen (S23) eines Dichtelements (41) zwischen der Basisplatte (9) und dem Gehäuse (7) des Getrieberaumes (3);
Verbinden (S25) der Abdeckung (21) durch erste Befestigungselemente (29) mit dem Gehäuse (7) des Getrieberaumes (3).

## Claims

1. Plated-through hole element (1) for arrangement between a transmission compartment (3) and an engine compartment (5), the plated-through hole element (1) having
a base plate (9) in which a recess (11) is provided;
a submodule (13, 15, 17) having electrical lines (19);
wherein the submodule (13, 15, 17) is arranged in the recess (11) of the base plate (9);
**characterized in that**
the submodule (13, 15, 17) is connected to the base plate (9) in a cohesive and oil-tight manner; and
**in that** the plated-through hole element (1) is designed to separate the transmission compartment (3) from the engine compartment (5) in an oil-tight manner.

2. Plated-through hole element (1) according to Claim 1,
wherein the submodule (13, 15, 17) is designed as a sensor, plug, clutch and/or distributor.

3. Plated-through hole element (1) according to either of Claims 1 and 2,
further having
a cover (21);
wherein the cover (21) is arranged on a side of the base plate (9) that faces the engine compartment (5);
wherein the cover (21) can be fastened to a housing (7) of the transmission compartment (3) by means of first fastening elements (29).

4. Plated-through hole element (1) according to Claim 3,
wherein the cover (21) is fastened to the side of the base plate (9) that faces the engine compartment (5) by second fastening elements (31).

5. Electronic control module (27), the control module (27) having
a circuit carrier (23) with electronic components (25); a plated-through hole element (1) according to one of Claims 1 to 4;
wherein the electronic components (25) are electrically connected to the submodule (13, 15, 17);
wherein the circuit carrier (23) is arranged on a side of the base plate (9) that faces the engine compartment (5) ;
wherein the circuit carrier (23) has a plastic material.

6. Electronic control module (27) according to Claim 5,
wherein the electronic components (25) are arranged on a side of the circuit carrier (23) that faces the engine compartment (5).

7. Electronic control module (27) according to either of Claims 5 and 6,
wherein the circuit carrier (23) is fastened to the cover (21) by third fastening elements (33).

8. Method for assembling an electronic control module (27) according to one of Claims 5 to 7, the method comprising the following steps:
providing (S1) a base plate (9) having a recess (11);
providing (S3a, S3b, S3c) a submodule (13, 15, 17) having lines (19);
providing (S5) a circuit carrier (23);
passing (S9) the submodule (13, 15, 17) through the recess (11);
connecting (S11) the electrical lines (19) of the submodule (13, 15, 17) to the circuit carrier (23);
**characterized in that** the method further comprises connecting (S13) the submodule (13, 15, 17) to the base plate (9) in a cohesive and oil-tight manner.

9. Method according to Claim 8, further comprising providing (S7) a cover (21);
fastening (S15) the cover (21) to the base plate (9) by second fastening elements (31).

10. Method according to Claim 8, further comprising providing (S7) a cover (21);
connecting (S11) the electrical lines (19) of the submodule (13, 15, 17) to the circuit carrier (23) before the submodule (13, 15, 17) is connected to the base plate (9);
fastening (S19) the circuit carrier (23) to the cover (21) by the third fastening elements (33) before the submodule (13, 15, 17) is connected to the base plate (9) .

11. Method according to either of Claims 9 and 10, further comprising
arranging (S21) the base plate (9) on a housing (7) of a transmission compartment (3) between the transmission compartment (3) and an engine compartment (5);
providing (S23) a sealing element (41) between the base plate (9) and the housing (7) of the transmission compartment (3);
connecting (S25) the cover (21) to the housing (7) of the transmission compartment (3) by first fastening elements (29).

## Revendications

1. Elément de métallisation traversante (1) destiné à être disposé entre un compartiment de boîte de transmission (3) et un compartiment moteur (5), l'élément de métallisation traversante (1) comportant une plaque de base (9) dans laquelle il est prévu un évidement (11) ;
un sous-module (13, 15, 17) comportant des conducteurs électriques (19) ;
dans lequel le sous-module (13, 15, 17) est disposé dans l'évidement (11) de la plaque de base (9) ; **caractérisé en ce que** le sous-module (13, 15, 17) est relié par complémentarité de matériau et de manière étanche à l'huile à la plaque de base (9) ; et
**en ce que** l'élément de métallisation traversante (1) est réalisé de façon à séparer manière étanche à l'huile le compartiment de boîte de transmission (3) du compartiment moteur (5).

2. Elément de métallisation traversante (1) selon la revendication 1, dans lequel le sous-module (13, 15, 17) est réalisé sous la forme d'un capteur, d'une fiche, d'un embrayage et/ou d'un distributeur.

3. Elément de métallisation traversante (1) selon l'une quelconque des revendications 1 et 2, comportant en outre un couvercle (21) ;
dans lequel le couvercle (21) est disposé sur une face de la plaque de base (9) qui est tournée vers le compartiment moteur (5) ;
dans lequel le couvercle (21) peut être fixé au moyen de premiers éléments de fixation (29) à un boîtier (7) du compartiment de boîte de transmission (3).

4. Elément de métallisation traversante (1) selon la revendication 3, dans lequel le couvercle (21) est fixé par des deuxièmes éléments de fixation (31) à la face de la plaque de base (9) qui est tournée vers le compartiment moteur (5).

5. Module de commande électronique (27), le module de commande (27) comportant
un support de circuit (23) muni de composants électroniques (25) ;
un élément de métallisation traversante (1) selon l'une quelconque des revendications 1 à 4 ;
dans lequel les composants électroniques (25) sont électriquement reliés au sous-module (13, 15, 17) ;
dans lequel le support de circuit (23) est disposé sur une face de la plaque de base (9) qui est tournée vers le compartiment moteur (5) ;
dans lequel le support de circuit (23) comporte un matériau de matière plastique.

6. Module de commande électronique (27) selon la revendication 5, dans lequel les composants électroniques (25) sont disposés sur une face du support de circuit (23) qui est tournée vers le compartiment moteur (5).

7. Module de commande électronique (27) selon l'une quelconque des revendications 5 et 6, dans lequel le support de circuit (23) est fixé au couvercle (21) par des troisièmes éléments de fixation (33).

8. Procédé de montage d'un module de commande électronique (27) selon l'une quelconque des revendications 5 à 7, le procédé comportant les étapes consistant à
fournir (S1) une plaque de base (9) comportant un évidement (11) ;
fournir (S3a, S3b, S3c) un sous-module (13, 15, 17) comportant des conducteurs (19) ;
fournir (S5) un support de circuit (23) ;
introduire (S9) le sous-module (13, 15, 17) à travers l'évidement (11) ;
relier (S11) les conducteurs électriques (19) du sous-module (13, 15, 17) au support de circuit (23) ; **caractérisé en ce que** le procédé consiste en outre à relier (S13) le sous-module (13, 15, 17) à la plaque de base (9) par complémentarité de matériau et de manière étanche à l'huile.

9. Procédé selon la revendication 8, consistant en outre à
fournir (S7) un couvercle (21) ;
fixer (S15) le couvercle (21) à la plaque de base (9) par des deuxièmes éléments de fixation (31).

10. Procédé selon la revendication 8, consistant en outre à
fournir (S7) un couvercle (21) ;
relier (S11) les conducteurs électriques (19) du sous-module (13, 15, 17) au support de circuit (23) avant de relier le sous-module (13, 15, 17) à la plaque de base (9) ;
fixer (S19) le support de circuit (23) par des troisièmes éléments de fixation (33) au couvercle (21) avant de relier le sous-module (13, 15, 17) à la plaque de base (9).

11. Procédé selon l'une quelconque des revendications 9 et 10, consistant en outre à disposer (S21) la plaque de base (9) sur un boîtier (7) d'un compartiment de boîte de transmission (3) entre le compartiment de boîte de transmission (3) et un compartiment moteur (5) ;
prévoir (S23) un élément d'étanchéité (41) entre la plaque de base (9) et le boîtier (7) du compartiment de boîte de transmission (3) ;
relier (S25) le couvercle (21) au boîtier (7) du compartiment de boîte de transmission (3) par des premiers éléments de fixation (29).
